# FASCICULE DE BREVET EUROPEEN

(11) **EP 2 773 912 B1**
(45) Date de publication et mention de la délivrance du brevet: **10.01.2018**
(21) Numéro de dépôt: 12790453.0
(22) Date de dépôt: 02.11.2012
(51) Int. Cl.: F24J 2/46, F24J 2/52, F24J 2/54, H01L 31/042, H01L 31/05, H02S 20/10, H02S 20/23, H02S 20/30

(54) **FERME SOLAIRE, TABLE SOLAIRE EQUIPANT UNE TELLE FERME SOLAIRE ET PROCEDE DE CONSTRUCTION D'UNE TELLE FERME SOLAIRE.**
SOLARPARK, SOLARTISCH FÜR EINEN SOLCHEN SOLARPARK UND VERFAHREN ZUR HERSTELLUNG SOLCH EINES SOLARPARKS
SOLAR FARM, SOLAR TABLE FOR SUCH A SOLAR FARM AND METHOD FOR CONSTRUCTING SUCH A SOLAR FARM

(30) Priorité: 02.11.2011 FR 1159917
(43) Date de publication de la demande: 10.09.2014
(73) Titulaire: Redavia, 69100 Villeurbanne (FR)
(72) Inventeur: SPOLDERS, Erwin, 80469 Munich (DE); HEINZLER, Daniel, 76316 Malsch (DE)
(74) Mandataire: Lavoix
(86) Numéro de dépôt international: PCT/EP2012/071707
(87) Numéro de publication internationale: WO 2013/064624

(56) Documents cités:
- WO-A1-2010/118236
- WO-A2-2010/129087
- AU-A1- 2011 211 412
- US-A1- 2010 212 715

## Description

La présente invention concerne une ferme solaire. L'invention concerne également une table solaire équipant une telle ferme solaire et un procédé de construction d'une telle ferme solaire.

Le domaine de l'invention est celui des centrales de production d'énergie renouvelable, solaire photovoltaïque ou solaire hybride.

L'invention se rapporte en particulier aux fermes solaires de grande capacité, c'est-à-dire ayant une capacité de production d'énergie supérieure à 1 « Mégawatt crête » (MWc), de préférence supérieure à 10 MWc. En alternative, l'invention peut être mise en oeuvre pour une ferme solaire de petite capacité, comprise entre 3 à 300kWc environ.

De manière connue, une ferme solaire de grande capacité peut être installée sur un terrain nu, puis connectée à un réseau national ou régional de transport et de distribution d'énergie. Actuellement, une telle ferme solaire est conçue pour être installée et maintenue sur le même site pour un minimum de 20 à 30 ans. Les exploitants doivent donc s'assurer que le coût de la construction soit rentabilisé, une fois la ferme installée, par un contrat de vente d'énergie couvrant cette même durée. L'investissement est important et potentiellement risqué, ce qui freine le déploiement de fermes solaires dans les pays les moins développés et les moins solvables.

Généralement, les éléments constitutifs d'une ferme solaire photovoltaïque arrivent entièrement désassemblés sur le site de construction. Des milliers de poutres de structure, modules photovoltaïque et câbles électrique doivent être assemblés directement sur le site. Les poutres sont vissées ensemble et ancrées dans le sol pour former la structure. Les modules sont levés avec soin en raison de leur fragilité, puis fixés à la structure. Les câbles électriques sont déployés sur l'ensemble de la structure et connectés aux modules, afin de les relier à une station onduleur/transformateur centralisée, elle-même raccordée au réseau de distribution d'énergie. Avec une telle méthode de construction traditionnelle, il peut s'écouler de 3 à 12 mois avant que la ferme solaire soit opérationnelle et que le premier kilo Watt heure (kWh) d'énergie soit délivré au réseau électrique et/ou à l'utilisateur final. A titre d'exemple, une ferme solaire traditionnelle d'une capacité de 10 MWc peut être opérationnelle après environ 3 à 6 mois de travaux.

En outre, les modules photovoltaïques existants ne sont pas adaptés pour produire une importante tension (V). En pratique, plusieurs modules sont connectés en série pour former des chaînes de modules (« module strings » en anglais) constitutives de la ferme solaire. Le but de telles chaînes est d'augmenter la tension dans les câbles de courant continu, pour améliorer l'efficacité du transport d'énergie électrique générée par les modules jusqu'à l'onduleur. Habituellement, les modules de 60 cellules standards présentent une capacité individuelle d'environ 230 Wc, avec une tension en sortie de 30 Volts. Afin d'obtenir la tension DC de sortie désirée, correspondant typiquement aux onduleurs 2X500 kilovoltampères (kVA), une chaîne typique comprend environ 20 modules connectés en série, et la ferme solaire comprend elle-même plusieurs dizaines ou même centaines de chaînes connectées en réseau. Un tel agencement implique une multiplication importante du nombre de câbles et de boîtes de jonction des modules photovoltaïques, ce qui demande un grand nombre d'opérations de montage et rallonge la durée d'installation.

De plus, la plupart des modules photovoltaïques existants sont encadrés pour améliorer leur rigidité. De tels modules comprennent un panneau de verre stratifié qui contient les cellules photovoltaïques et est monté dans un cadre métallique, notamment en aluminium. Le cadre vise à rigidifier le module et empêcher la casse du panneau de verre stratifié, en particulier durant le transport ou l'installation. Lorsque le module est monté sur la structure de support, la rigidité combinée de la structure et des cadres de modules est trop élevée en comparaison avec les contraintes mécaniques subies par la ferme solaire et les modules (cellules/panneau de verre). Il en résulte un gaspillage de matériau, en volume et en masse, devant être transporté puis installé, ce qui accroit inutilement le coût global de la ferme solaire.

Par ailleurs, la plupart des modules photovoltaïques existants comprennent soixante cellules standards, typiquement des cellules en silicone poly-cristallin mesurant chacune 156 millimètres par 156 millimètres, et présentent donc une taille de 1,60 mètre par 1 mètre, pour une épaisseur de cadre de 50 millimètres environ. Pour chaque module, les soixante cellules sont connectées avec 6x10 cellules en série reliées à une boite de connexion. Chaque module comporte une telle boite, de laquelle sortent deux câbles de module (pôles positif et négatif). Cette taille est pratique si les modules doivent être manipulés manuellement par des installateurs, mais la tension de sortie individuelle de chaque module (tension à puissance maximale Pmax = environ 30V) est trop faible pour un transport d'énergie efficace sur une distance de centaine de mètres, comme souvent nécessaire dans les fermes solaires de grand taille. Aussi, la tension d'entrée d'onduleurs centraux utilisés pour des fermes solaires de grande taille est souvent au moins 350V. Pour cette raison, souvent environ 20 modules sont connectés en série pour augmenter la tension globale de la chaine. Ce mauvais ajustement entre la taille des modules et la tension de chaine optimale crée un gaspillage de matériel (environ 20 boites de connexion intermédiaires, et environ 40 câbles de modules intermédiaires).

Il existe également des générateurs solaires ou hybrides de faible capacité (de l'ordre de quelques kWc ou dizaines de kWc, dans tous les cas inférieure à 1 MWc), transportables notamment par conteneur, où le conteneur en lui-même devient un composant de la ferme solaire. Typiquement, un tel générateur comprend des panneaux solaires monté sur le toit du conteneur. Ces générateurs sont sous-dimensionnés pour une connexion en réseau efficace et ne permettent pas de réaliser des fermes solaires performantes pour un coût raisonnable, en particulier du fait du grand nombre de conteneurs requis pour obtenir 1 MWc.

US-A-2010 212 715 décrit une table solaire, une ferme solaire comprenant plusieurs tables solaires et un procédé de construction d'une telle ferme solaire. Chaque table comprend un cadre supportant des panneaux photovoltaïques, ainsi qu'une structure de poutres triangulées (« truss structure » en anglais) pliables et dépliables. De telles tables sont complexes et coûteuses à fabriquer. La structure de poutres triangulées représente une masse additionnelle importante et rallonge la durée d'installation des tables. En outre, les cadres des tables solaires peuvent être empilés les uns sur les autres durant leur transport, mais un risque de coincement existe en raison du profil en partie incliné des cadres. Par ailleurs, lors de sa fabrication, la table solaire n'inclut pas l'ensemble des câbles de transport d'énergie électrique générée par les modules photovoltaïques à destination de l'onduleur, en particulier les câbles prévus pour relier des chaînes de tables solaires.

De manière classique, le cadre et les panneaux photovoltaïques sont transportés depuis un site de fabrication vers un site d'installation, puis les câbles électriques sont disposés sur les tables solaires directement sur le site d'installation, par un électricien différent du fabricant. La tendance est d'avoir le moins de câbles possibles, les plus longs possibles, pour faciliter le travail de l'électricien. En effet, un nombre plus élevé de segments de câbles et donc de prises augmente les risques d'erreur de connexion sur le site d'installation. Toutefois, les câbles longs sont plus difficiles à manipuler et plus encombrants lors du chargement, du déchargement et de l'installation de la ferme solaire.

Le but de la présente invention est de proposer une ferme solaire améliorée.

A cet effet, l'invention a pour objet une ferme solaire, comprenant au moins un onduleur et au moins deux tables solaires reliées par des câbles électriques à l'onduleur ou à l'un des onduleurs, chaque table solaire étant adaptée pour reposer sur au moins deux jambes d'appui au sol. La ferme solaire est caractérisée en ce que chaque table solaire est préfabriquée à des fins de transport et/ou d'installation en incluant au moins les éléments suivants :
- un cadre parallélépipédique comportant quatre poutres allongées, deux à deux opposées, parmi lesquelles :
   - deux poutres opposées d'un premier type sont conformées avec des profils de section transversale polygonale, et
   - deux poutres opposées d'un deuxième type sont munies chacune de moyens mécaniques de fixation du cadre à l'une des jambes d'appui ;
- au moins un module photovoltaïque fixé au cadre ; et
- des segments de câbles de transport d'énergie électrique générée par le ou les modules photovoltaïques à destination de l'onduleur, les segments de câbles étant attachés sur l'essentiel de leur longueur à au moins l'une des poutres du premier type et/ou logés sur l'essentiel de leur longueur dans un volume libre délimité à l'intérieur d'au moins l'une des poutres du premier type, le nombre, la longueur, le diamètre et/ou le matériau des segments de câbles intégrés à la ou chaque table solaire étant fonction de sa position prédéterminée dans la ferme solaire.

L'invention a également pour objet une table solaire, destinée notamment à équiper une telle ferme solaire. La table solaire est préfabriquée à des fins de transport et/ou d'installation en incluant les éléments suivants :
- un cadre parallélépipédique comportant quatre poutres allongées, deux à deux opposées, parmi lesquelles :
   - deux poutres opposées d'un premier type sont conformées avec des profils de section transversale polygonale adaptés pour l'empilement l'une sur l'autre et le calage transversal d'au moins deux tables solaires, notamment à des fins de transport dans un conteneur de transport selon les standards ISO, et
   - deux poutres opposées d'un deuxième type sont munies chacune de moyens mécaniques de fixation du cadre à une jambe d'appui ;
- au moins un module photovoltaïque fixé au cadre ; et
- des segments de câbles de transport d'énergie électrique générée par le ou les modules photovoltaïques à destination de l'onduleur, les segments de câbles étant attachés sur l'essentiel de leur longueur à au moins l'une des poutres du premier type et/ou logés sur l'essentiel de leur longueur dans un volume libre délimité à l'intérieur d'au moins l'une des poutres du premier type, le nombre, la longueur, le diamètre et/ou le matériau des segments de câbles intégrés à la table solaire étant fonction de sa position prédéterminée dans la ferme solaire.

Ainsi, l'invention permet d'obtenir une ferme solaire de grande capacité, en un laps de temps et pour un coût réduits par rapport aux fermes solaires existantes. La préfabrication des tables solaires évite de devoir emballer et transporter un grand nombre de composants. En outre, la réduction du nombre de composants à assembler et emballer permet un gain de temps lors de la fabrication et de l'installation, et donc une diminution globale du coût de main d'oeuvre. En effet, la légère augmentation du coût d'assemblage dans l'usine de fabrication est largement compensée par la réduction du coût d'emballage et du coût d'assemblage sur site. Une fois débarquées du conteneur de transport, les tables solaires sont prêtes à installées. De plus, le coût correspondant aux cadres support des modules est réduit. La construction des tables solaires qui équipent la ferme solaire est donc particulièrement avantageuse, facilitant à la fois le transport depuis le site de fabrication vers le site d'installation, l'installation de la ferme sur un terrain nu, mais également le démontage et le redéploiement de la ferme en cas de besoin.

Dans le cadre de l'invention, le fait de prévoir l'agencement des segments de câbles pour chaque table solaire, avant son assemblage et son transport, demande un travail préparatoire plus important. En outre, la connexion de nombreux segments de câbles sur le site d'installation demande une rigueur importante. Intégrer des segments de câbles électriques au cadre, à distance du site d'installation, ne présente donc pas un caractère évident. En vainquant les préjugés de l'homme du métier, et à l'encontre des idées reçues dans le domaine, l'invention permet un important gain de temps et donc d'argent lors du déchargement et de l'installation de la ferme solaire sur site.

Selon d'autres caractéristiques avantageuses de l'invention, prises isolément ou en combinaison :
- Chaque table solaire comprend des segments de câbles dont la longueur est comprise entre 95 % et 120 % de la longueur des poutres du premier type et dont le nombre est fonction de la position prédéterminée de la table solaire dans la ferme solaire.
- Lorsque la ferme solaire est installée, les segments de câbles forment des chaînes de câbles qui s'étendent le long de chaînes de tables solaires, le nombre de chaîne de câbles disposées en parallèle étant, d'une part, fonction de la position prédéterminée de la chaîne de tables solaires dans la ferme solaire et, d'autre part, différent pour des chaînes de tables solaires voisines.
- Chaque table solaire est adaptée pour partager une même jambe d'appui avec une table solaire adjacente, lorsqu'au moins deux tables solaires sont installées au sol l'une à côté de l'autre avec des poutres du deuxième type adjacentes, la jambe d'appui étant fixée aux moyens de fixation équipant les poutres du deuxième type adjacentes des deux tables solaires.
- La ferme solaire comprend au moins neuf tables solaires installées au sol, accolées sur au moins trois lignes et au moins trois colonnes, au moins certaines des tables solaires bordées par moins de huit tables solaires comprenant des troisièmes moyens mécaniques de fixation au cadre d'une troisième jambe d'appui.
- Pour chaque table solaire, les poutres du premier type s'étendent suivant une première longueur, les poutres du deuxième type s'étendent suivant une deuxième longueur, la première longueur étant supérieure à la deuxième longueur, notamment la première longueur est supérieure à 8 mètres, de préférence supérieure à 10 mètres, et la deuxième longueur est supérieure à 1,50 mètre, de préférence supérieure à 2 mètres.
- La table solaire comporte une poutre centrale de rigidification du cadre, cette poutre centrale s'étendant parallèlement aux deux poutres du premier type et reliant les deux poutres du deuxième type.
- Chaque table solaire comprend également des câbles d'équipotentalité entre tables solaires, ces câbles d'équipotentialité appartenant à un système de protection anti-foudre et étant fixés au cadre de la table solaire, de préférence lors de la fabrication de la table solaire.
- Au moins certaines des tables solaires comprennent au moins un module photovoltaïque incluant des cellules photovoltaïques individuelles connectées à une même boîte de jonction, notamment pour obtenir une tension de chaîne optimale directement en sortie de ce module photovoltaïque.
- Chacun des moyens mécaniques de fixation du cadre à l'une des jambes d'appui autorisent une liberté de mouvement de la table solaire par rapport à la jambe d'appui suivant une direction sensiblement parallèle aux poutres du premier type et verrouillent le positionnement relatif de la table solaire par rapport à la jambe d'appui dans toutes les autres directions de l'espace.

Avantageusement, dans la ferme solaire comprenant au moins deux tables solaires, chaque table solaire comprend des poutres du premier type conformées avec des profils de section transversale polygonale adaptés pour l'empilement l'une sur l'autre et le calage transversal d'au moins deux tables solaires dans le ou l'un des conteneurs, deux tables empilées présentant une hauteur inférieure à la somme de leurs hauteurs individuelles, la position relative des tables solaires empilées dans le ou les conteneurs étant fonction de leur position respective prédéterminée dans la ferme solaire.

L'invention a également pour objet un procédé de construction d'une ferme solaire, le procédé comprenant au moins des étapes successives suivantes :
- une étape a) de planification, d'une part, de la fabrication sur un premier site et, d'autre part, du déploiement sur un deuxième site distant du premier site, d'une ferme solaire comprenant au moins une table solaire ;
   - une sous-étape a1) de référencement de chaque table solaire en fonction de sa position d'installation dans la ferme solaire sur le deuxième site ;
   - une sous-étape a2) de détermination du nombre et/ou de la longueur de segments câbles de transport d'énergie électrique intégrés à chaque table solaire en fonction de son référencement dans la sous-étape de référencement a1);
- une étape b) de fabrication, sur le premier site, de chaque table solaire comprenant :
   - un cadre parallélépipédique comportant quatre poutres allongées, deux à deux opposées, parmi lesquelles :
      - deux poutres opposées d'un premier type sont conformées avec des profils de section transversale polygonale adaptés pour l'empilement l'une sur l'autre et le calage transversal d'au moins deux tables solaires, notamment à des fins de transport dans un conteneur de transport selon les standards ISO, et
      - deux poutres opposées d'un deuxième type sont munies chacune de moyens mécaniques de fixation au cadre d'une jambe d'appui ;
   - au moins un module photovoltaïque fixé au cadre, et
   - les segments de câbles attachés sur l'essentiel de leur longueur à au moins l'une des poutres du premier type et/ou logés sur l'essentiel de leur longueur dans un volume libre délimité à l'intérieur d'au moins l'une des poutres du premier type ;
- une étape c) de chargement de la ferme solaire dans au moins un conteneur de transport, de préférence à ouverture par le haut, chaque table solaire étant positionnée dans le ou l'un des conteneurs en fonction de son référencement dans la sous-étape de référencement a1), le cadre d'une table solaire étant notamment empilé sur le cadre de la table solaire précédemment chargée dans le conteneur ;
- une étape d) de transport des conteneurs depuis le premier site vers le deuxième site ;
- une étape e) d'installation de la ferme solaire sur le deuxième site, chaque table solaire formant un ensemble pré-assemblé monobloc durant son déchargement et son installation, réalisés notamment par le biais d'une machine de manutention de tables solaires, la position d'installation de chaque table solaire étant fonction de son référencement dans la sous-étape de référencement a1), les segments de câbles reliant les au moins deux tables solaires à l'onduleur ou à l'un des onduleurs et formant des chaînes de câbles qui s'étendent le long de chaînes de tables solaires, le nombre de chaînes de câbles disposées en parallèle étant notamment fonction de la position d'installation de chaque chaîne de table solaire dans la ferme solaire.

Grâce au procédé de construction selon l'invention, aucun segment de câble additionnel de transport d'énergie jusqu'à l'onduleur n'est fixé aux tables solaires sur le deuxième site. Pour relier les tables entre elles et les chaînes de tables entre elles, seules des connexions entre les prises d'extrémité des segments de câbles sont réalisées, ce qui permet un important gain de temps lors de l'installation de la ferme solaire.

L'invention sera mieux comprise à la lecture de la description qui va suivre, donnée uniquement à titre d'exemple non limitatif et faite en référence aux dessins annexés sur lesquels :
- la figure 1 est un schéma de principe d'une ferme solaire conforme à l'invention, la ferme solaire étant disposée dans l'hémisphère nord et comprenant plusieurs tables solaires également conformes à l'invention, les tables solaires étant fixées au sol et reliées électriquement à un onduleur ;
- la figure 2 est une vue de dessus d'une table solaire équipant la ferme solaire de la figure 1, la table comprenant un cadre, des modules photovoltaïques, des câbles de transport d'électricité, ainsi que des câbles d'équipotentalité entre tables faisant partie d'un système de protection anti-foudre, le cadre étant fixé sur des jambes d'appui au sol ;
- la figure 3 est une vue selon la flèche III à la figure 2 ;
- la figure 4 est une vue analogue à la figure 2, montrant uniquement le cadre et les moyens de fixation des jambes au cadre ;
- la figure 5 est une vue selon la flèche V à la figure 3 ;
- la figure 6 est une vue à plus grande échelle du détail VI à la figure 3 ;
- la figure 7 est une vue à plus grande échelle du détail VII à la figure 5 ;
- la figure 8 est une vue selon la flèche VIII à la figure 4, montrant uniquement le cadre et les moyens de fixation d'une jambe au cadre ;
- la figure 9 est une vue partielle analogue à la figure 8, montrant l'empilement à des fins de transport de trois poutres longitudinales appartenant à trois tables solaires ;
- la figure 10 est une vue à plus grande échelle du détail X à la figure 8 ;
- la figure 11 est une vue à plus grande échelle du détail XI à la figure 2 ;
- la figure 12 est une vue à plus grande échelle du détail XII à la figure 3 ; et
- la figure 13 est une vue à plus grande échelle du détail XIII à la figure 5.

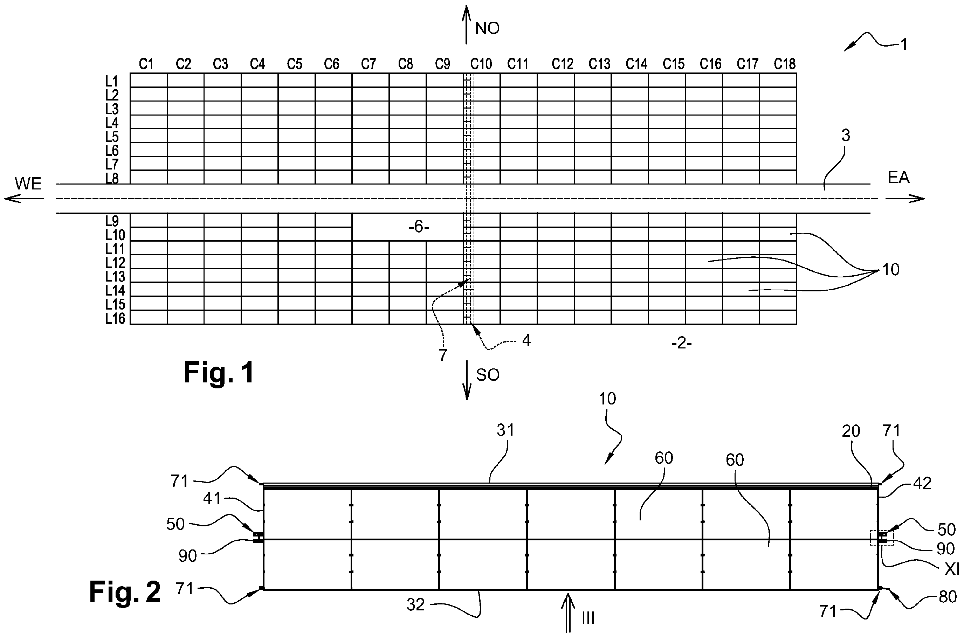

Sur la figure 1 est représentée une ferme solaire 1 conforme à l'invention.

Pour faciliter le repérage de la ferme 1 dans l'espace, les points cardinaux sont montrés à la figure 1 : nord NO, sud SO, est EA, ouest WE.

La ferme solaire 1 est installée sur un terrain 2, de part et d'autre d'une route 3 et d'une tranchée 4. Le terrain 2 est initialement nu et traversé suivant la direction est EA - ouest WE par la route 3, tandis que la tranchée 4 est creusée suivant la direction nord NO - sud SO lors de l'installation de la ferme 1 sur le site.

En alternative, la ferme solaire 1 peut être installée sur une structure existante ou un bâtiment, notamment le toit du bâtiment.

La ferme solaire 1 comprend une station onduleur / transformateur centralisée 6 et plusieurs tables solaires 10, également conformes à l'invention, équipées de cellules solaires photovoltaïques. Les tables 10 sont fixées au sol du terrain 2 par des jambes non visibles à la figure 1, qui sont par exemple des profilés métalliques. Sur l'exemple de la figure 1, les tables 10 formant la ferme solaire 1 sont agencées selon dix-huit colonnes C1 à C18 orientées suivant la direction est EA - ouest WE, ainsi que selon seize lignes L1 à L16 orientées suivant la direction nord NO - sud SO. Les lignes L1 à L8 sont situées au nord NO de la route 3, tandis que les lignes L9 à L16 sont situées au sud SO de la route 3. Les colonnes C1 à C9 sont situées à l'ouest WE de la tranchée 4, tandis que les colonnes C10 à C18 sont situées à l'est EA de la route 3.

Les tables 10 sont raccordées électriquement en chaînes comprenant chacune plusieurs tables 10, afin d'améliorer l'efficacité énergétique de l'ensemble. Les tables 10 formant une chaîne sont disposées en série suivant l'une des lignes L1 à L16, par exemple trois ou neuf tables 10. De préférence, le long d'une même ligne L1-L16, plusieurs chaînes de tables 10 peuvent être raccordées en série, pour des raisons d'efficacité énergétique. Par exemple pour la ligne L1, une première chaîne de trois tables 10 correspondant aux colonnes C1 à C3, une deuxième chaîne de trois tables 10 correspondant aux colonnes C4 à C6 et une troisième chaîne de trois tables 10 correspondant aux colonnes C7 à C9 peuvent être raccordées en série. Les chaînes de tables 10 sont reliées électriquement à l'onduleur 6 par des câbles 7 de transport d'énergie électrique qui sont disposés dans la tranchée 4.

Sur l'exemple de la figure 1, la station onduleur/transformateur 6 occupe une surface équivalente à une table 10, ce qui nécessite en fait d'occuper la place de deux chaînes de trois tables 10, sur l'emplacement correspondant aux colonnes C7 à C9 et aux lignes L9 et L10. La station 6 est adjacente à la route 3 et à la tranchée 4. Cette tranchée 4 est creusée sous la route 3, de manière à recevoir les câbles 7 en provenance de chaque chaîne de tables 10, de chaque ligne L1 à L16, pour les relier à l'onduleur de la station 6. A titre d'exemple, la station 6 peut livrer l'énergie en courant alternatif de 11 ou 20 kilovolts (kV). La station 6 peut être entièrement pré-assemblée, chargée en containeur ISO standard et livrée sur site en étant prête pour connexion et mise en service immédiate.

En pratique, la ferme solaire 1 est préfabriquée sur un site de production qui est généralement distant du site d'exploitation, à savoir le terrain 2. Autrement dit, la station onduleur/transformateur 6, les câbles 7, les tables 10 et les jambes d'appui au sol sont fabriquées dans un premier temps, puis répartis dans des conteneurs de transport maritime, ferroviaire et/ou routier pour être acheminés vers le terrain 2 dans un deuxième temps. Dans un troisième temps, les éléments constitutifs de la ferme solaire 1 sont déchargés sur le terrain 2 puis assemblés entre eux, avec un gain de temps conséquent par rapport aux installations traditionnelles. Le creusement de la tranchée 4, située à environ 50 centimètres vers l'est EA de la colonne de jambes centrale, est commencé après la pose des tables 10 du quadrant nord-est (L1-L8, C1-C9) de la ferme 1, et terminé après la pose des tables 10 du quadrant sud-est (L9-L16, C1-C9), mais avant la pose des tables 10 du quadrant nord-ouest (L1-L8, C10-C18) et du quadrant sud-ouest (L9-L16, C10-C18).

En particulier, les tables solaires 10 sont spécifiquement adaptées pour faciliter leur transport et leur installation, avec un encombrement réduit et une rigidité optimale, comme détaillé ci-après en référence aux figures 2 à 13. Chaque table solaire 10 forme un ensemble pré-assemblé monobloc durant son transport et son installation. Les tables solaires 10 ne comprennent aucune partie pliable/dépliable, qui pourrait fragiliser sa structure lors d'une opération de manutention et rallongerait sa durée d'installation sur le terrain 2. Selon un exemple préféré, chaque table 10 mesure environ 12 mètres de longueur pour 2 mètres de largeur et 0,2 mètres d'épaisseur, de sorte qu'un conteneur maritime standard ISO (par exemple, un conteneur cubique de 40 pieds de haut à ouverture par le haut, ISO 6346:1995) peut contenir dix-huit tables 10.

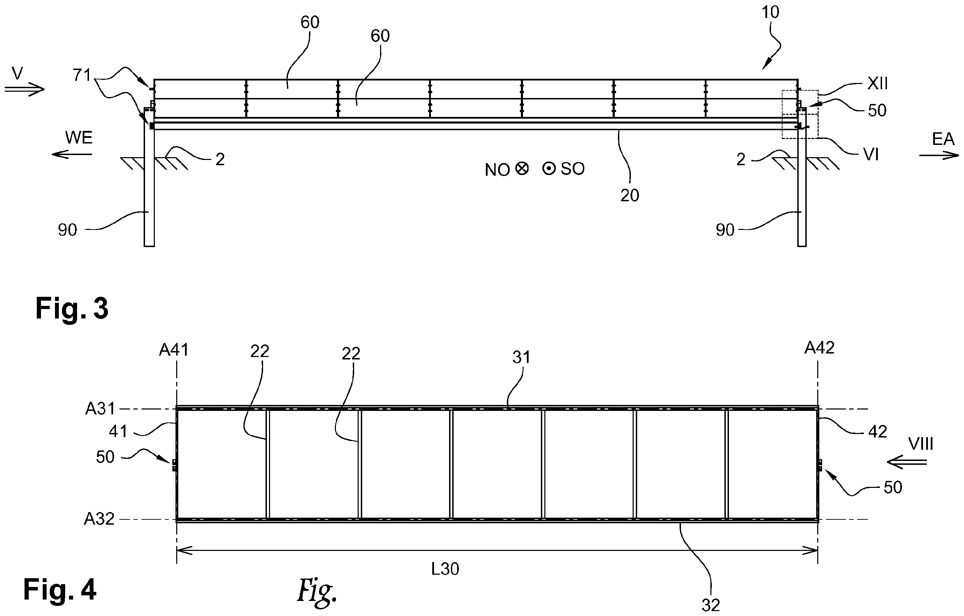

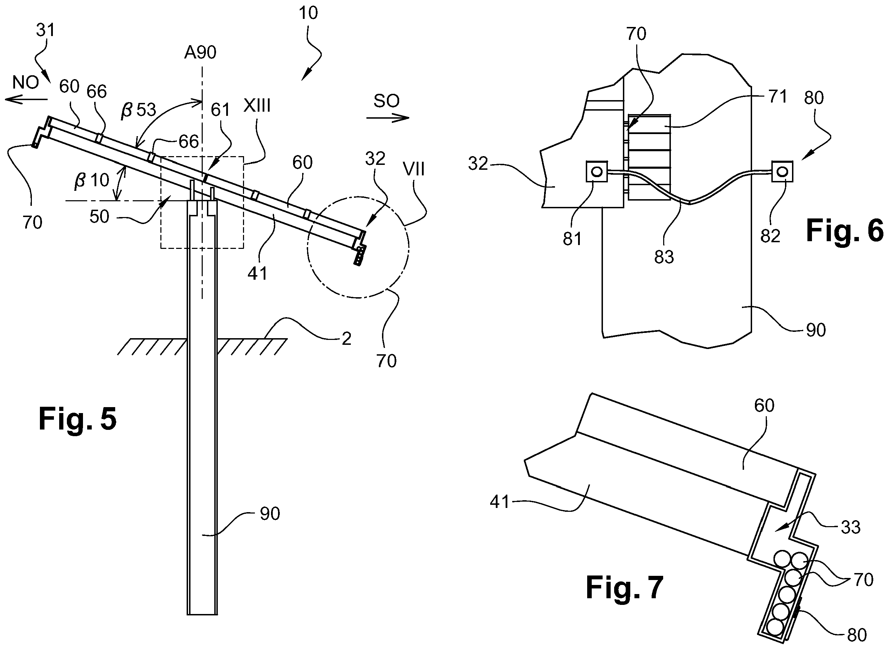

Lors de leur installation sur le terrain 2, les tables solaires 10 sont inclinées en direction du sud SO, comme montré ci-après aux figures 3 et 5, afin de capter au mieux le rayonnement solaire. Ceci est valable dans l'hémisphère nord du globe et doit être compris comme tel dans la description ci-après, étant entendu que dans l'hémisphère sud, les tables solaires 10 sont inclinées en direction du nord NO.

Du fait du grand nombre de tables 10 constituant la ferme solaire 1, à savoir deux cent quatre-vingt deux tables 10 sur l'exemple de la figure 1, la ferme 1 présente une capacité de production d'énergie importante, de l'ordre de 1 MWc. Le « Mégawatt crête » est une unité de puissance utilisée comme mesure de puissance en sortie des modules photovoltaïques, afin de décrire l'effet produit par les cellules solaires photovoltaïques équipant les tables 10 dans des conditions standardisées de haute isolation (« Standard Testing Conditions » ou STC en Anglais). La capacité exacte de la ferme 1 dépend de nombreux paramètres tels que l'ensoleillement du terrain 2, le nombre de tables 10, le type et l'agencement des cellules photovoltaïques équipant les tables 10, le rendement de la station onduleur/transformateur 6, l'efficacité électrique globale de la ferme 1, notamment les pertes dans les câbles 7 de transport d'énergie, etc.

En alternative, la ferme 1 peut être conformée différemment sans sortir du cadre de l'invention. Par exemple, le terrain 2 peut être démuni de route 3 et/ou de tranchée 4. Selon un autre exemple, la ferme 1 peut comprendre un nombre différent de tables 10, dans tous les cas au moins une table 10, de préférence au moins une centaine de tables 10. Selon un autre exemple, les chaînes peuvent comprendre un nombre différent de tables 10, de préférence au moins trois tables 10. Selon un autre exemple, la ferme 1 peut être hybride, c'est-à-dire inclure également un ou des générateurs hydrauliques, éoliens, diesel, biodiesel ou autres sources d'électricité. Selon un autre exemple, la ferme 1 peut comprendre un système d'onduleur décentralisé, dans lequel chaque ligne L1-L16 ou plusieurs (deux, trois) lignes L1-L16 de tables 10 sont munies d'un onduleur décentralisé. Dans ce cas, la station centrale 6 de la ferme 1 ne comprend pas un onduleur centralisé mais seulement un transformateur et des équipements périphériques, comme des boites de protection, climatisation, etc.

Sur les figures 2 à 13 est représentée une table solaire 10 équipant la ferme solaire 1 selon l'invention.

La table solaire 10 inclut un cadre 20 globalement parallélépipédique, des modules photovoltaïques 60 fixés au cadre 20, des câbles 70 de transport d'énergie électrique générée par les modules 60, ainsi que des câbles 80 d'équipotentalité entre tables 10 adjacentes. Ces câbles 80 font partie du système de protection anti-foudre de la ferme 1, conformément aux normes en vigueur. La table 10 est adaptée pour reposer sur deux jambes 90 d'appui au sol 2. De préférence, les jambes 90 sont au moins en partie enterrées sous la surface du sol 2, comme montré aux figures 3 et 5. A titre d'exemple non limitatif, les jambes 90 s'étendent suivant leurs axes A90 respectifs sur environ 2,5 mètres de hauteur, tandis que la distance entre le sol 2 et le point le plus bas de la table 10 est d'environ 60 centimètres.

Comme montré aux figures 2 à 4, les modules photovoltaïques 60 équipant la table 10 sont au nombre de quatorze, disposées en deux rangées de sept modules 60. Chaque module 60 est un panneau de verre stratifié intégrant des cellules photovoltaïques, par exemple soixante cellules adjacentes. Dans ce cas, chaque table 10 intègre huit cent quarante cellules. Chaque module 60 peut être encadré par son propre cadre d'aluminium ou, de préférence, être dénué de cadre en aluminium. A titre d'exemple non limitatif, chaque module mesure environ 1,60 mètre par 1 mètre, pour une épaisseur de 50 millimètres (avec cadre). Ceci correspond aux dimensions approximatives de la majorité des modules fabriqués actuellement.

Lors de la fabrication de la table 10, les modules 60 sont fixés directement et rigidement au cadre 20. Un espace intermédiaire 61 sépare les deux rangées de modules 60. Des crochets de maintien 66 des modules 61 sont positionnés entre les modules 60 d'une même rangée et sur le cadre 20, en bordure de cette rangée. Pour chaque table 10, chaque rangée de sept modules 60 est déjà connectée en série dans l'usine, créant deux « mini-chaînes » de sept modules 60 chacune sur la table 10. Cela permet de connecter les mini-chaînes de sept modules 60 de trois tables 10 adjacentes pour arriver à une chaîne de vingt et un modules 60, ce qui est augmente la tension dans la chaîne au niveau d'entrée souhaité pour un fonctionnement optimal de l'onduleur dans la station onduleur/transformateur 6.

En alternative, la table 10 peut comprendre un nombre différent de modules 60, même en gardant le nombre de huit cent quarante cellules individuelles par table 10. Par exemple, au lieu de connecter sept modules 60 (de soixante cellules chacun, donc quatre cent vingt cellules), pour arriver à une mini-chaîne de sept modules 60, la table 10 peut être fournie avec le même nombre de cellules, celles-ci étant connectées dans seulement deux modules 60. Chacun de ces « méga-modules » de 420 cellules a seulement une boite de connexion et deux câbles (pôles plus et moins). Cela permet de réduire le nombre de boites de connexion et le nombre et/ou les dimensions des câbles 70 de modules par rapport aux sept boites de connexion et 14 câbles de la « mini-chaîne » de sept modules 60 traditionnels de soixante cellules chacun. Selon un autre exemple, la table 10 peut comporter un ou plusieurs modules incluant au moins cent vingt cellules photovoltaïques individuelles connectées à une même boîte de jonction. Un tel « méga-module » est un objet qui peut être considéré indépendamment des autres objets de l'invention, à savoir la ferme solaire 1 et la table solaire 10.

Quel que soit le nombre de modules 60 équipant la table 10, la connexion entre modules 60 peut être avantageusement optimisée : une réduction du nombre de modules 60 équipant la table 10 implique une réduction du nombre de boîtes de connexion et de câbles 70 reliant les modules 60, ce qui constitue une économie de matériel.

Le cadre 20 comporte quatre poutres 31, 32, 41 et 42, deux à deux opposées. Plus précisément, le cadre 20 comporte deux poutres opposées 31 et 32 d'un premier type, à savoir des poutres longitudinales s'étendant respectivement suivant des axes parallèles A31 et A32, ainsi que deux poutres opposées d'un deuxième type 41 et 42, à savoir des poutres latérales s'étendant respectivement suivant des axes parallèles A41 et A42. Les poutres longitudinales 31 et 32 présentent une longueur L30, tandis que les poutres latérales 41 et 42 présentent une longueur L40. La longueur L30 est supérieure à la longueur L40, notamment la longueur L30 est supérieure à 8 mètres, de préférence supérieure à 10 mètres, tandis que la deuxième longueur L40 est supérieure à 1,5 mètre, de préférence supérieure à 2 mètres. Sur l'exemple des figures 1 à 13, la longueur L30 mesure environ 12 mètres, tandis que la longueur L40 mesure environ 2,10 mètres. Les poutres 31, 32, 41 et 42 sont de préférence en acier galvanisé, qui présente un bon compromis entre résistance mécanique et compacité. En alternative, le cadre 20 peut être en tout type de matériau métallique ou composite adapté à la présente application. Lors de la fabrication du cadre 20, les poutres 31, 32, 41 et 42 sont de préférence soudées entre elles. Le cadre 20 est rigide et ne comprend aucune partie pliable/dépliable. Le cadre 20 suffit à rigidifier la table 10, qui ne comprend donc aucune partie de structure pliable/dépliable.

Lorsque la table 10 est installée sur ses jambes 90 fixées au sol 2, les poutres 31 et 32 s'étendent suivant la direction est EA - ouest WE, avec la poutre 32 qui est plus rapprochée du sol 2 que la poutre 31, tandis que les poutres 41 et 42 s'étendent suivant la direction nord NO - sud SO, en étant inclinées vers le sol 2 du côté sud SO. Autrement dit, le cadre 20 est globalement incliné en direction du sud SO, de manière à optimiser l'exposition des modules photovoltaïques 60 au rayonnement solaire. Sur l'exemple de la figure 5, la table 10 est inclinée d'un angle β10 égal à 20 degrés par rapport à un plan horizontal sensiblement parallèle au sol 2. En alternative, la table 10 peut être inclinée vers le sud SO d'un angle β10 compris entre 0 et 35 degrés

Les poutres longitudinales 31 et 32 sont creuses et délimitent chacune un volume intérieur libre, respectivement 33 et 34, dans lesquels sont disposés les câbles 70 lors de la fabrication de la table 10. En alternative, les câbles 70 peuvent être attachés sur l'une des poutres ou sur les poutres 31 et 32, à l'extérieur des volumes 33 et 34, lors de la fabrication de la table 10.

Le nombre, la longueur, le diamètre et/ou le matériau particulier des câbles 70 intégrés à la table solaire 10 sont fonction de la position prédéterminée de cette table 10 dans la ferme solaire 1. Ces paramètres associés aux câbles 10 sont déterminés lorsque la construction de la ferme solaire 1 est planifiée, autrement dit prédéterminés avant la fabrication de la table 10. La résistance et la conductivité d'un câble 70 dépendent en particulier de son matériau (aluminium ou cuivre par exemple) et de son diamètre. L'ensemble des câbles 70 de la ferme solaire 1 comprend des segments différents prédéterminés et pré-assemblés pour chaque table 10, et non pas un unique câble pour chaque ligne L1-L18 ou chaque colonne C1-C18. Autrement dit, chaque câble 70 intégré à une table 10 est un segment individuel, formant un unique maillon d'une chaîne de câbles 70 de la ferme solaire 1. Les segments de câble 70 présentent une longueur sensiblement égale à la longueur L30 des poutres longitudinales 31 et 32, c'est-à-dire comprise entre 95 % et 105 % de cette longueur L30, ou bien comprise entre 105 % et 120 % de cette longueur L30 pour raccord aux câbles 7 dans le cas des tables 10 bordant la tranchée 4. Autrement dit, chaque segment de câbles 70 pré-intégré à une table 10 présente de préférence une longueur comprise entre 95 % et 120 % de la longueur L30. Sur le site d'installation, il n'est donc pas nécessaire de rajouter de petits segments de câbles non pré-assemblés aux tables 10, ni de fixer des câbles de plusieurs dizaines de mètres de long aux tables 10.

Sur chaque ligne L1 à L16, différents segments forment des chaînes de câbles 70 qui s'étendent le long des colonnes C1 à C9 et des chaînes de câbles 70 qui s'étend le long des colonnes C10 à C18. En l'espèce, une série de segments de câbles 70 connectés bout à bout par des fiches d'extrémité 71 forme une chaîne de câbles 70 qui s'étend le long d'une chaîne de tables 10 et est raccordée à une chaîne de câbles 70 disposée le long d'une chaîne de tables 10 voisines, formant ainsi une plus longue chaîne de câbles 70 qui s'étend le long d'une plus longue chaîne de tables 10.

A titre d'exemple non limitatif, la ligne L1 comprend, pour chacune des poutres 31 et 32, une première chaîne de câbles 70 qui s'étend le long des colonnes C1-C9, une deuxième chaîne de câbles 70 qui s'étend le long des colonnes C4-C9 et une troisième chaîne de câbles 70 qui s'étend le long des colonnes C7-C9, soit six chaînes en parallèle pour la seule ligne L1. En d'autres termes, les segments de câbles 70 forment des chaînes de câbles 70 qui s'étendent le long de chaînes de tables solaires 10, le nombre de chaînes de câbles 70 disposés en parallèle étant, d'une part, fonction de la position prédéterminée de la chaîne de tables solaires 10 dans la ferme solaire 1 et, d'autre part, différent pour des chaînes de tables solaires 10 voisines.

Les poutres 31 et 32 sont symétriques par rapport à un plan médian parallèle aux axes A31 et A32. Les poutres 31 et 32 sont conformées avec des profils de section polygonale, transversalement à leurs axes respectifs A31 et A32. Ainsi, les profils des poutres 31 et 32 sont adaptés pour l'empilement l'une sur l'autre et le calage transversal d'au moins deux tables solaires 10, notamment à des fins de transport dans un conteneur. Pour faciliter la fabrication des poutres 31 et 32, ainsi que leur empilement, il est possible d'arrondir les coins du profil des poutres.

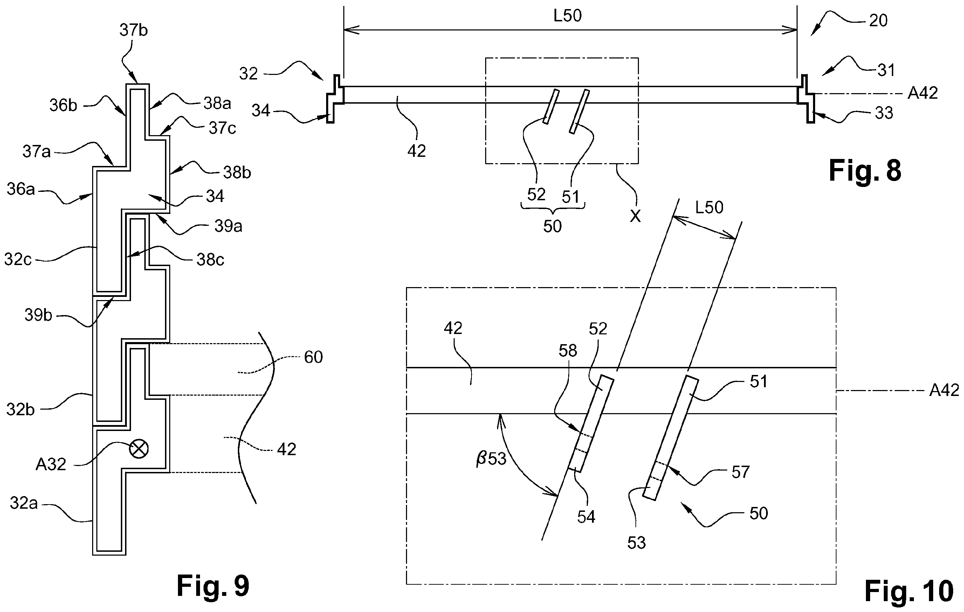

La figure 9 montre trois poutres longitudinales 32a, 32b et 32c empilées l'une sur l'autre à des fins de transport. A titre d'exemple, un conteneur maritime standard peut comprendre environ dix-huit tables 10 empilées l'une sur l'autre. La table 10 à laquelle appartient la poutre 32a est chargée la première, puis celle de la poutre 32b, puis de la poutre 32c. La poutre 42 solidaire de la poutre 32a et l'un des modules 60 reposant sur ces poutres 32a et 42 sont montrées en pointillés. La poutre 32c, de même que toutes les poutres 31, 32, 32a, 32b, comprend deux faces 36a et 36b orientées vers l'extérieur du cadre 20, trois faces 37a, 37b et 37c orientées vers le côté supérieur du cadre 20, trois faces 38a, 38b et 38c orientées vers l'intérieur du cadre 20, ainsi que deux faces 39a et 39b orientées vers le côté inférieur du cadre 20. Les côtés supérieur et inférieur du cadre 20 sont définis respectivement à l'opposé et en direction du sol 2 lorsque le cadre 20 est monté sur les jambes 90. Les faces 36a, 36b, 38a, 38b et 38c sont perpendiculaires aux faces 37a, 37b, 37c, 39a et 39b. La perpendicularité des faces voisines du profil est préférée, dans la mesure où elle permet d'éviter un risque de coincement des cadres superposés lors de l'empilement ou le désempilement des tables 10. Les coins entre faces voisines peuvent être arrondis pour faciliter la fabrication et l'empilement des poutres 31 et 32. Lorsque la poutre 32c est empilée sur la poutre 32b, les faces 39a, 38c et 39b de la poutre 32c viennent en appui respectivement sur les faces 37b, 36b et 37a de la poutre 32b. La poutre 42 s'étend depuis la face 38b, tandis que le module 60 est fixé aux faces 38a et 37c. En alternative, le profil polygonal des poutres 31 et 32 peut comprendre un nombre différent de faces, de préférence au moins deux faces tournées de chaque côté.

Ainsi, les cadres 20 peuvent être facilement empilés, avec les poutres 31 et 32 qui remplissent une fonction de calage transversal aux axes A31 et A32 durant le transport des tables 10. Lors du chargement ou déchargement des tables 10, les cadres 20 peuvent glisser les uns sur les autres parallèlement aux axes A31 et A32. Durant toutes ces opérations, les modules 60 sont avantageusement protégés des chocs et autres dommages. En outre, deux tables 10 empilées présentant une hauteur inférieure à la somme de leurs hauteurs individuelles. La hauteur est mesurée perpendiculairement au plan de la table 10, autrement dit perpendiculairement aux axes A31 et A32.

Comme montré à la figure 7, les câbles 70 relient chaque table 10 de la ferme 1 à une table 10 adjacente ou à un câble 7 à destination de l'onduleur dans la station onduleur/transformateur 6. Les câbles 70 sont logés sur l'essentiel de leur longueur dans les volumes libres 33 et 34 délimités à l'intérieur des poutres longitudinales 31 et 32, ou dans le volume 31 ou 34 délimité dans au moins l'une des poutres 31 et 32, ce qui permet avantageusement d'assembler les câbles dans l'usine de fabrication et non pas sur le site. Au niveau des poutres latérales 41 et 42, comme montré en particulier à la figure 6, les câbles 70 se terminent par des fiches 71 de connexion à une table 10 adjacente. Ces fiches 71 facilitent le raccordement entre tables 10 pour la formation des mini-chaînes de vingt-et-un modules 60 disposés en série, ainsi que la connexion de chaque de ces séries à l'onduleur dans la station onduleur/transformateur 6. Pour cette connexion des chaînes de modules 60, chaque table 10 contient exactement le bon nombre de câbles 70 dans les poutres longitudinales 31 et 32. Ce nombre correct de câbles 70, ainsi que leur longueur, diamètre et matériau dépendent du positionnement (défini par la ligne L1-L18 et la colonne C1-C18) de la table 10 dans la ferme 1. Ainsi, l'ensemble du câblage des chaines peut être pré-assemblé dans l'usine de fabrication, en laissant le minimum d'opérations d'assemblage sur le terrain nu 2, ce qui réduit le coût et les délais d'installation de la ferme 1 sur site.

Comme montré à la figure 6, la table solaire 10 comprend également des câbles 80 d'équipotentalité entre les tables, qui font partie du système de protection anti-foudre fixé au cadre 20. Plus précisément, les câbles 80 incluent un élément conducteur 81 fixé à la poutre 32, un élément conducteur 82 destiné à être fixé au cadre 20 d'une table 10 adjacente, ainsi qu'un fil électrique conducteur 83 reliant les éléments 81 et 82. Au sein d'une ligne de plusieurs tables 10, l'une de ces tables 10 comprend des moyens 80 spécifiquement reliés à la masse du sol 2 et/ou au système de parafoudre en sous-sol. Ces moyens 80 sont de préférence fixées sur la table 10 lors de sa fabrication. Les moyens 80 sont obligatoires d'après les normes internationales relatives aux équipements de production d'énergie solaire.

Par ailleurs, les poutres latérales 41 et 42 sont munies chacune de moyens mécaniques 50 de fixation au cadre 20 d'une jambe d'appui 90. Des premiers moyens mécaniques 50 sont solidaires de la poutre 41, tandis que des deuxièmes moyens mécaniques 50 sont solidaires de la poutre 42.

Plus précisément, deux organes allongés 51 et 52 sont soudés à chacune des poutres 41 et 42, du côté extérieur du cadre 20. De préférence, les organes 51 et 52 sont réalisés en acier galvanisé ou inoxydable. Les organes 51 et 52 sont inclinés du côté de la poutre 32 en formant un angle β53 par rapport à la poutre 42. En pratique, la valeur de l'angle β53 détermine la valeur de l'angle β10 d'inclinaison des tables 10. La somme de ces angles complémentaires β10 et β53 est égale à 90 degrés. La longueur de l'organe 51 est environ 20 centimètres, tandis que la longueur de l'organe 52 est environ 15 centimètres. L'organe 51 est plus long que l'organe 52, de sorte que leurs extrémités inférieures respectives 53 et 54 opposées à la poutre 42 se trouvent sensiblement dans un même plan horizontal. Un orifice traversant 57 est ménagé dans l'extrémité 53 de l'organe 51, tandis qu'un orifice traversant 58 est ménagé dans l'extrémité 54 de l'organe 52. Les orifices 57 et 58 sont alignés suivant un axe parallèle à l'axe A41 ou A42. Les organes 51 et 52 sont séparés par un écart L50 de l'ordre de 10 centimètres, défini dans le plan horizontal et suivant une direction sécante aux axes A41 et A42. En alternative, les organes 51 et 52 peuvent être soudés sur une plaque intermédiaire, qui est vissée directement sur la poutre 41 ou 42, soit de préférence lors de la fabrication des tables 10, soit lors de l'installation de la ferme 1 sur le terrain 2.

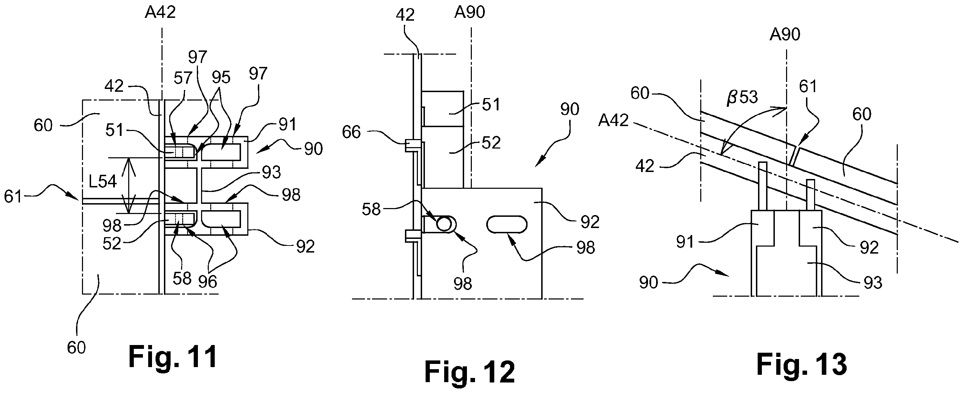

Les jambes 90 se présentent comme des poteaux en acier, de préférence en acier galvanisé ou inoxydable, destinés être ancrées rigidement dans le sol 2 pour supporter la table 10. Comme montré en particulier à la figure 11, chaque jambe 90 présente un profil en H, avec deux branches 91 et 92 reliées par une partie intermédiaire 93. L'extrémité inférieure de la jambe 90 est adaptée pour être ancrée dans le sol 2. Les branches 91 et 92 sont creuses au niveau de l'extrémité supérieure de la jambe 90 destinée à être raccordée au cadre 20. Les branches 91 et 92 délimitent chacune deux évidements, respectivement 95 pour la branche 91 et 96 pour la branche 92, qui s'étendent dans la jambe 90 parallèlement à son axe longitudinal A90 et débouchent à son extrémité supérieure. Quatre trous oblongs 97 sont ménagés dans la branche 91, avec deux trous 97 débouchant de part et d'autre de chaque évidement 95 suivant une direction perpendiculaire à l'axe A90. De même, quatre trous oblongs 98 sont ménagés dans la branche 92, avec deux trous 98 débouchant de part et d'autre de chaque évidement 96 suivant une direction perpendiculaire à l'axe A90.

La partie 93 de la jambe 90 définit un plan vertical comprenant l'axe A90, avec un évidement 95, un évidement 96, deux trous 97 et deux trous 98 disposés de chaque côté de ce plan vertical. Les éléments 95-98 situés d'un premier côté du plan vertical sont adaptés pour recevoir les moyens 50 appartenant à une première table 10, tandis que les éléments 95-98 situés d'un deuxième côté du plan vertical sont adaptés pour recevoir les moyens 50 appartenant à une deuxième table 10 adjacente à la première table 10. Ainsi, deux tables 10 installées au sol 2 l'une à côté de l'autre, avec des poutres 41 et 42 adjacentes, sont adaptées pour partager une même jambe d'appui 90 fixée aux moyens de fixation 50 équipant les poutres 31 et 32 adjacentes des deux tables solaires 10.

Lorsque la table 10 est montée sur ses deux jambes 90, chaque organe 51 est enfoncé dans un évidement 95 et chaque organe 52 est enfoncé dans un évidement 96. Les orifices 57 et 58 sont alors alignés avec les trous oblongs 97 et 98. Des boulons non représentés peuvent ensuite être utilisés pour fixer rigidement les moyens 50 solidaires du cadre 20 aux jambes 90. Un premier boulon est disposé à travers l'orifice 57 et les trous 97, tandis qu'un deuxième boulon est disposé à travers l'orifice 58 et les trous 98. La forme oblongue des trous 97 et 98 autorise un jeu de montage des moyens 50 par rapport à la jambe 90 suivant une direction perpendiculaire aux axes A41, A42 et A90, mais aucun jeu suivant une direction parallèle à l'axe A90.

Grâce à la construction particulière des moyens 50 et de la jambe 90, les tables solaires 10 peuvent être, d'une part, facilement montées lors de l'installation de la ferme 1, avec une connexion statique rigide par rapport aux jambes 90 et, d'autre part, facilement démontées lors du redéploiement éventuel de la ferme 1. En particulier, les moyens mécaniques 50 de fixation du cadre 20 à l'une des jambes d'appui 90 autorisent une liberté de mouvement de la table solaire 10 par rapport à la jambe d'appui 90 suivant une direction sensiblement parallèle aux poutres du premier type 31 et 32 et verrouillent le positionnement relatif de la table solaire 10 par rapport à la jambe d'appui 90 dans toutes les autres directions de l'espace.

En pratique, les principales contraintes mécaniques subies par les éléments constitutifs de la ferme 1 ne sont pas dues au poids des tables 10 exercées sur les jambes 90, mais à la force du vent susceptible de souffler sur la ferme 1. Les risques associés au vent sont l'arrachement des tables 10 par rapport aux jambes 90, l'arrachement des jambes 90 par rapport au sol 2, l'arrachement des modules 60 par rapport au cadre 20 et la déformation du cadre 20. Dans ces conditions, la construction des moyens 50 et de la jambe 90 assure une résistance optimale à l'arrachement des tables 10 par rapport aux jambes 90 sous l'effet du vent. Les poutres 31, 32, 41 et 42 procurent une résistance mécanique satisfaisante au cadre 20, adaptée à ses dimensions importantes. Les modules 60 sont solidarisés au cadre 20, notamment par vissage, de sorte que leur arrachement est empêché.

Comme montré à la figure 4, le cadre 20 comporte également six poutres 22 qui s'étendent entre les poutres 31 et 32, parallèlement aux poutres 41 et 42. Ces poutres 22 sont également prévues pour supporter les modules 60, ainsi qu'une partie des crochets 66 de maintien des modules 60 les uns par rapport aux autres et par rapport au cadre 20. Le nombre de poutres 22 dépend du nombre de modules 60 équipant la table 10. Autrement dit ces poutres 22 sont optionnelles, par exemple dans le cas où la table 10 est équipée d'un unique module 60 où de deux modules 60 s'étendant sur toute la longueur L30 du cadre 20. De préférence, les différentes poutres 22, 31, 32, 41 et 42 constituant le cadre 20 sont en acier galvanisé ou inoxydable. Encore de préférence, les modules 60 ne comprennent pas de cadres propres et sont supportés uniquement par le cadre 20, de sorte que les tables solaires 10 sont démunies d'aluminium.

En outre, les tables solaires 10 peuvent être conformées différemment des figures 1 à 13 sans sortir du cadre de l'invention.

En variante non représentée, le cadre 20 peut également être rigidifié à l'aide d'une poutre centrale. Dans ce cas, cette poutre centrale s'étend parallèlement aux poutres 31 et 32 en reliant les deux poutres 41 et 42. Cette alternative est préférée dans le cas d'utilisation de modules 60 non-cadrés.

Selon une autre variante non représentée, les profils de section polygonale transversale des poutres 31 et 32 peuvent être conformés différemment de l'exemple des figures. Dans le cadre de l'invention, ces profils permettent l'empilement et le calage transversal des tables 10 dans les conteneurs de transport.

Selon une autre variante non représentée, les moyens de fixation 50 peuvent être adaptés pour faire varier et ajuster l'angle β10 d'inclinaison de la table 10 et des modules 60. Par exemple, les organes 51 et 52 peuvent être montés en liaison pivot par rapport aux poutres 41 et 42, de manière à présenter un angle β53 variable. Des moyens 50 ajustables permettent à la table 10 d'être préfabriquée puis déployée sous différentes latitudes, avec une inclinaison optimale des modules 60 par rapport au soleil à chaque endroit / latitude de déploiement.

Selon une autre variante non représentée, le profil, la longueur et la largeur des jambes 90 peuvent être différents sans sortir du cadre de l'invention. En pratique, différents sites d'installation correspondent à différentes contraintes opérationnelles (sol, vent, ...), ce qui implique l'utilisation de jambes 90 particulières.

Par ailleurs, en considérant la ferme 1 de la figure 1 dans sa globalité, il est remarquable que les tables 10 peuvent ne pas être toutes identiques. En pratique, certaines tables 10 sont plus exposées au vent et peuvent donc nécessiter un ancrage plus solide dans le sol du terrain 2. C'est le cas notamment des tables 10 situées sur les lignes L1, L8, L9 et L16, ainsi que sur les colonnes C1, C9, C10 et C18.

Ainsi, de préférence, au moins certaines des tables 10 composant la ferme 1 peuvent être adaptées pour reposer sur trois jambes 90. Autrement dit, lorsque la ferme 1 comprend au moins neuf tables 10 accolées sur au moins trois lignes et au moins trois colonnes, alors au moins certaines de ces tables 10, notamment celles bordées par moins de huit tables 10 voisines, comprennent des troisièmes moyens mécaniques 50 de fixation au cadre 20 d'une troisième jambe d'appui 90. En complément ou en alternative, au moins certaines des tables 10 peuvent être munies d'une poutre centrale de rigidification du cadre 20, comme décrit plus haut. Dans tous les cas, les tables 10 destinées à former la ferme 1 présentent un minimum de différences structurelles, de manière à pouvoir être fabriquées et assemblées en utilisant le même procédé de base à l'usine de fabrication.

De préférence, une majorité des tables 10 sont adaptées pour reposer chacune uniquement sur deux jambes 90, en partageant ces jambes 90 avec des tables 10 adjacentes. Cela minimise le nombre total de jambes 90 et réduit le coût de montage et de démontage de la ferme solaire 1. Comme chaque table 10 est installée sur un emplacement spécifique du terrain nu 2, qui peut être plus ou moins accidenté, surélevé et/ou incliné par rapport aux emplacements voisins, la longueur des différentes jambes 90 équipant la ferme 1 peut varier. Par conséquent, les jambes 90 prévues pour une ferme solaire 1 installée sur un terrain 2 donné ne sont pas toutes réutilisables sur un autre site. Dans ces conditions, un nombre plus réduit de jambes 90 signifie une réduction du nombre de pièces potentiellement non réutilisables.

Quel que soit le mode de réalisation de la ferme 1 ou de la table 10, le cadre 20 est préassemblé avec les modules photovoltaïques 60 et les câbles 70 directement dans l'usine de production, sur un premier site, de manière à réduire les étapes d'assemblage des tables solaires 10 sur le terrain 2, c'est-à-dire sur un deuxième site distant du premier site. Chaque table solaire 10 destinée à former la ferme solaire 1 peut être emballée, transportée et déployée en n'importe quel point du globe pour un coût réduit. De cette manière, l'installation de la ferme 1 d'un MWc prend environ une semaine maximum et il en est de même pour le démontage. Les contrats d'exploitation peuvent être de courte durée, par exemple de 1 à 3 ans. Egalement, la ferme solaire 1 peut être financée plus facilement, indépendamment de la situation particulière du terrain 2 sur la planète.

Dans le cas où la ferme solaire 1 comprend uniquement une table solaire 10, l'onduleur de la station 6 peut optionnellement être fixé directement sur le cadre 20.

En outre, les caractéristiques techniques des différents modes de réalisation peuvent être, en totalité ou pour certaines d'entre elles, combinées entre elles. Ainsi, les tables solaires 10 et la ferme solaire 1 peuvent être adaptées en termes de coût et de contraintes opérationnelles.

## Revendications

1. Ferme solaire (1), comprenant au moins un onduleur et au moins deux tables solaires (10) reliées par des câbles électriques (7, 70) à l'onduleur ou à l'un des onduleurs (6), chaque table solaire (10) étant adaptée pour reposer sur au moins deux jambes (90) d'appui au sol (2), **caractérisée en ce que** chaque table solaire (10) est préfabriquée à des fins de transport et/ou d'installation en incluant au moins les éléments (20, 50, 60, 70) suivants :
- un cadre parallélépipédique (20) comportant quatre poutres allongées (31, 32, 41, 42), deux à deux opposées, parmi lesquelles :
- deux poutres opposées d'un premier type (31, 32) sont conformées avec des profils de section transversale polygonale, et
- deux poutres opposées d'un deuxième type (41, 42) sont munies chacune de moyens mécaniques (50) de fixation du cadre (20) à une des jambes d'appui (90);
- au moins un module photovoltaïque (60) fixé au cadre (20) ; et
- des segments de câbles (70) de transport d'énergie électrique générée par le ou les modules photovoltaïques (60) à destination de l'onduleur, les segments de câbles (70) étant attachés sur l'essentiel de leur longueur à au moins l'une des poutres du premier type (31, 32) et/ou logés sur l'essentiel de leur longueur dans un volume libre (33, 34) délimité à l'intérieur d'au moins l'une des poutres du premier type (31, 32), le nombre, la longueur, le diamètre et/ou le matériau des segments de câbles (70) intégrés à chaque table solaire (10) étant fonction de sa position prédéterminée dans la ferme solaire (1).

2. Ferme solaire (1) selon la revendication 1, **caractérisée en ce que** chaque table solaire (10) comprend des segments de câbles (70) dont la longueur est comprise entre 95 % et 120 % de la longueur (L30) des poutres du premier type (31, 32) et dont le nombre est fonction de la position prédéterminée de c table solaire (10) dans la ferme solaire (1).

3. Ferme solaire (1) selon l'une quelconque des revendications précédentes, **caractérisée en ce que** lorsque la ferme solaire (1) est installée, les segments de câbles (70) forment des chaînes de câbles qui s'étendent le long de chaînes de tables solaires (10), le nombre de chaîne de câbles disposées en parallèle étant, d'une part, fonction de la position prédéterminée de la chaîne de tables solaires (10) dans la ferme solaire (1) et, d'autre part, différent pour des chaînes de tables solaires (10) voisines.

4. Ferme solaire (1) selon l'une quelconque des revendications précédentes, **caractérisée en ce que** chaque table solaire (10) est adaptée pour partager une même jambe d'appui (90) avec une table solaire adjacente, lorsqu'au moins deux tables solaires (10) sont installées au sol (2) l'une à côté de l'autre avec des poutres du deuxième type (41, 42) adjacentes, la jambe d'appui (90) étant fixée aux moyens de fixation (50) équipant les poutres du deuxième type (41, 42) adjacentes des deux tables solaires (10).

5. Ferme solaire (1) selon l'une quelconque des revendications précédentes, **caractérisée en ce qu'**elle comprend au moins neuf tables solaires (10) installées au sol (2), accolées sur au moins trois lignes (L1-L18) et au moins trois colonnes (C1-C18), au moins certaines des tables solaires (10) bordées par moins de huit tables solaires comprenant des troisièmes moyens mécaniques (50) de fixation au cadre (20) d'une troisième jambe d'appui (90).

6. Ferme solaire (1) selon l'une quelconque des revendications précédentes, **caractérisée en ce que** chaque table solaire (10) comprend également des câbles (80) d'équipotentalité entre tables solaires, ces câbles d'équipotentialité appartenant à un système de protection anti-foudre et étant fixés au cadre (20) de la table solaire (10), de préférence lors de la fabrication de la table solaire (10).

7. Ferme solaire (1) selon l'une quelconque des revendications précédentes, **caractérisée en ce qu'**au moins certaines des tables solaires (10) comprennent au moins un module photovoltaïque incluant des cellules photovoltaïques individuelles connectées à une même boîte de jonction, notamment pour obtenir une tension de chaîne optimale directement en sortie de ce module photovoltaïque.

8. Ferme solaire (1) selon l'une quelconque des revendications précédentes, **caractérisée en ce que** chaque table solaire (10) comprend des poutres du premier type (31, 32) conformées avec des profils de section transversale polygonale adaptés pour l'empilement l'une sur l'autre et le calage transversal d'au moins deux tables solaires (10) dans le ou l'un des conteneurs, deux tables (10) empilées présentant une hauteur inférieure à la somme de leurs hauteurs individuelles, la position relative des tables solaires (10) empilées dans le ou les conteneurs étant fonction de leur position respective prédéterminée dans la ferme solaire (1).

9. Table solaire (10), notamment destinée à équiper une ferme solaire (1) selon l'une quelconque des revendications 1 à 8, la table solaire (10) étant préfabriquée à des fins de transport et/ou d'installation en incluant au moins les éléments suivants (20, 50, 60, 70) :
- un cadre parallélépipédique (20) comportant quatre poutres allongées (31, 32, 41, 42), deux à deux opposées, parmi lesquelles :
- deux poutres opposées d'un premier type (31, 32) sont conformées avec des profils de section transversale polygonale adaptés pour l'empilement l'une sur l'autre et le calage transversal d'au moins deux tables solaires (10), notamment à des fins de transport dans un conteneur de transport selon les standards ISO, et
- deux poutres opposées d'un deuxième type (41, 42) sont munies chacune de moyens mécaniques (50) de fixation du cadre (20) à une jambe d'appui (90) ;
- au moins un module photovoltaïque (60) fixé au cadre (20) ; et
- des segments de câbles (70) de transport d'énergie électrique générée par le ou les modules photovoltaïques (60) à destination de l'onduleur, les segments de câbles (70) étant attachés sur l'essentiel de leur longueur à au moins l'une des poutres du premier type (31, 32) et/ou logés sur l'essentiel de leur longueur dans un volume libre (33, 34) délimité à l'intérieur d'au moins l'une des poutres du premier type (31, 32), le nombre, la longueur, le diamètre et/ou le matériau des segments de câbles (70) intégrés à la table solaire (10) étant fonction de sa position prédéterminée dans la ferme solaire (1).

10. Table solaire (10) selon la revendication 9, **caractérisée en ce que** les poutres du premier type (31, 32) s'étendent suivant une première longueur (L30), les poutres du deuxième type (41, 42) s'étendent suivant une deuxième longueur (L40), la première longueur (L30) étant supérieure à la deuxième longueur (L40) :
- la première longueur (L30) est supérieure à 8 mètres, de préférence supérieure à 10 mètres, et
- la deuxième longueur (L40) est supérieure à 1,50 mètre, de préférence supérieure à 2 mètres.

11. Table solaire (10) selon l'une quelconque des revendications 9 ou 10, **caractérisée en ce qu'**elle comporte une poutre centrale de rigidification du cadre (20), cette poutre centrale s'étendant parallèlement aux deux poutres du premier type (31, 32) et reliant les deux poutres du deuxième type (41, 42).

12. Table solaire (10) selon l'une quelconque des revendications 9 à 11, **caractérisée en ce que** chacun des moyens mécaniques (50) de fixation du cadre (20) à l'une des jambes d'appui (90) autorisent une liberté de mouvement de la table solaire (10) par rapport à la jambe d'appui (90) suivant une direction sensiblement parallèle aux poutres du premier type (31, 32) et verrouillent le positionnement relatif de la table solaire (10) par rapport à la jambe d'appui (90) dans toutes les autres directions de l'espace.

13. Procédé de construction d'une ferme solaire (1) selon l'une quelconque des revendications 1 à 8, le procédé comprenant au moins des étapes successives suivantes :
- une étape a) de planification, d'une part, de la fabrication sur un premier site et, d'autre part, du déploiement sur un deuxième site (2) distant du premier site, d'une ferme solaire (1) comprenant au moins une table solaire (10) ;
- une sous-étape a1) de référencement de chaque table solaire (10) en fonction de sa position d'installation dans la ferme solaire (1) sur le deuxième site (2) ;
- une sous-étape a2) de détermination du nombre et/ou de la longueur de segments de câbles (70) de transport d'énergie électrique intégrés à chaque table solaire (10) en fonction de son référencement dans la sous-étape de référencement a1) ;
- une étape b) de fabrication, sur le premier site, de chaque table solaire (10) comprenant :
- un cadre parallélépipédique (20) comportant quatre poutres allongées (31, 32, 41, 42), deux à deux opposées, parmi lesquelles :
- deux poutres opposées d'un premier type (31, 32) sont conformées avec des profils de section transversale polygonale adaptés pour l'empilement l'une sur l'autre et le calage transversal d'au moins deux tables solaires (10), notamment à des fins de transport dans un conteneur de transport selon les standards ISO, et
- deux poutres opposées d'un deuxième type (41, 42) sont munies chacune de moyens mécaniques (50) de fixation au cadre (20) d'une jambe d'appui (90);
- au moins un module photovoltaïque (60) fixé au cadre (20), et
- les segments de câbles (70) attachés sur l'essentiel de leur longueur à au moins l'une des poutres du premier type (31, 32) et/ou logés sur l'essentiel de leur longueur dans un volume libre (33, 34) délimité à l'intérieur d'au moins l'une des poutres du premier type (31, 32) ;
- une étape c) de chargement de la ferme solaire (1) dans au moins un conteneur de transport, de préférence à ouverture par le haut, chaque table solaire (10) étant positionnée dans le ou l'un des conteneurs en fonction de son référencement dans la sous-étape de référencement a1), le cadre (20) d'une table solaire (10) étant notamment empilé sur le cadre (20) de la table solaire (10) précédemment chargée dans le conteneur ;
- une étape d) de transport des conteneurs depuis le premier site vers le deuxième site ;
- une étape e) d'installation de la ferme solaire (1) sur le deuxième site (2), chaque table solaire (10) formant un ensemble pré-assemblé monobloc durant son déchargement et son installation, réalisés notamment par le biais d'une machine de manutention de tables solaires (10), la position d'installation de chaque table solaire (10) étant fonction de son référencement dans la sous-étape de référencement a1), les segments de câbles (70) reliant les au moins deux tables solaires (10) à l'onduleur ou à l'un des onduleurs (6) et formant des chaînes de câbles qui s'étendent le long de chaînes de tables solaires (10), le nombre de chaînes de câbles (70) disposées en parallèle étant notamment fonction de la position d'installation de chaque chaîne de table solaire (10) dans la ferme solaire (1).

## Patentansprüche

1. Solarpark (1), mindestens einen Wechselrichter und mindestens zwei Solartische (10) aufweisend, die über Elektrokabel (7, 70) an den Wechselrichter oder an den einen der Wechselrichter (6) angeschlossen sind, wobei jeder Solartisch (10) dazu angepasst ist, auf mindestens zwei Beinen (90) zum Abstützen am Boden (2) aufzuliegen, **dadurch gekennzeichnet, dass** jeder Solartisch (10) zu Transport- und/oder Installationszwecken vorgefertigt ist und zumindest die folgenden Elemente (20, 50, 60, 70) beinhaltet:
- einen quaderförmigen Rahmen (20) mit vier langgestreckten, paarweise entgegengesetzten Trägern (31, 32, 41, 42), von denen:
- zwei entgegengesetzte Träger eines ersten Typs (31, 32) mit Profilen polygonalen Querschnitts ausgestaltet sind, und
- zwei entgegengesetzte Träger eines zweiten Typs (41, 42) jeweils mit mechanischen Einrichtungen (50) zur Befestigung des Rahmens (20) an einem der Stützbeine (90) ausgestattet sind;
- mindestens ein Photovoltaikmodul (60), das am Rahmen (20) befestigt ist; und
- Kabelsegmente (70) zum Transport elektrischer Energie, die von dem oder den Photovoltaikmodulen (60) erzeugt wurde, zum Wechselrichter, wobei die Kabelsegmente (70) über im Wesentlichen ihre Länge an mindestens einem der Träger des ersten Typs (31, 32) angebracht und/oder über im Wesentlichen ihre Länge in einem freien Volumen (33, 34) aufgenommen sind, das im Inneren mindestens eines der Träger des ersten Typs (31, 32) abgegrenzt ist, wobei die Anzahl, die Länge, der Durchmesser und/oder das Material der Kabelsegmente (70), die in jeden Solartisch (10) integriert sind, von seiner vorbestimmten Position im Solarpark (1) abhängen.

2. Solarpark (1) nach Anspruch 1, **dadurch gekennzeichnet, dass** jeder Solartisch (10) Kabelsegmente (70) aufweist, deren Länge zwischen 95% und 120% der Länge (L30) der Träger des ersten Typs (31, 32) beträgt, und deren Anzahl von der vorbestimmten Position c des Solartischs (10) im Solarpark (1) abhängt.

3. Solarpark (1) nach einem der vorhergehenden Ansprüche, **dadurch gekennzeichnet, dass**, wenn der Solarpark (1) installiert ist, die Kabelsegmente (70) Ketten von Kabeln bilden, die sich entlang von Ketten von Solartischen (10) erstrecken, wobei die Anzahl an parallel angeordneten Ketten von Kabeln einerseits von der vorbestimmten Position der Ketten von Solartischen (10) im Solarpark (1) abhängt und andererseits für benachbarte Ketten von Solartischen (10) unterschiedlich ist.

4. Solarpark (1) nach einem der vorhergehenden Ansprüche, **dadurch gekennzeichnet, dass** jeder Solartisch (10) dazu angepasst ist, sich ein und dasselbe Stützbein (90) mit einem angrenzenden Solartisch zu teilen, wenn mindestens zwei Solartische (10) nebeneinander mit aneinander angrenzenden Trägern des zweiten Typs (41, 42) am Boden (2) installiert sind, wobei das Stützbein (90) an den Befestigungseinrichtungen (50) befestigt ist, mit denen die aneinander angrenzenden Träger des zweiten Typs (41, 42) der zwei Solartische (10) ausgestattet sind.

5. Solarpark (1) nach einem der vorhergehenden Ansprüche, **dadurch gekennzeichnet, dass** er mindestens neun Solartische (10) aufweist, die am Boden (2) installiert, in mindestens drei Reihen (L1 - L18) und mindestens drei Spalten (C1 - C18) aufgereiht sind, wobei zumindest manche der Solartische (10), die von mindestens acht Solartischen umsäumt sind, dritte mechanische Einrichtungen (50) zur Befestigung eines dritten Stützbeins (90) am Rahmen (20) aufweisen.

6. Solarpark (1) nach einem der vorhergehenden Ansprüche, **dadurch gekennzeichnet, dass** jeder Solartisch (10) auch Potentialausgleichsleitungen (80) zwischen Solartischen aufweist, wobei diese Potentialausgleichsleitungen zu einem Blitzschutzsystem gehören und am Rahmen (20) des Solartischs (10) vorzugsweise bei der Herstellung des Solartischs (10) befestigt werden.

7. Solarpark (1) nach einem der vorhergehenden Ansprüche, **dadurch gekennzeichnet, dass** zumindest manche der Solartische (10) mindestens ein Photovoltaikmodul aufweisen, das einzelne Photovoltaikzellen enthält, die an ein und dieselbe Anschlussdose angeschlossen sind, insbesondere, um direkt am Ausgang dieses Photovoltaikmoduls eine optimale Kettenspannung zu erreichen.

8. Solarpark (1) nach einem der vorhergehenden Ansprüche, **dadurch gekennzeichnet, dass** jeder Solartisch (10) Träger eines ersten Typs (31, 32) aufweist, die mit Profilen polygonalen Querschnitts ausgestaltet und zum Aufeinanderstapeln und Querverstauen mindestens zweier Solartische (10) in dem oder einem der Container angepasst sind, wobei zwei gestapelte Tische (10) eine Höhe aufweisen, die niedriger ist als die Summe ihrer einzelnen Höhen, wobei die relative Position der in dem oder den Container/n gestapelten Solartische (10) von ihrer jeweiligen vorbestimmten Position im Solarpark (1) abhängt.

9. Solartisch (10), der insbesondere dazu bestimmt ist, einen Solarpark (1) nach einem der Ansprüche 1 bis 8 auszurüsten, wobei der Solartisch (10) zu Transport- und/oder Installationszwecken vorgefertigt ist und zumindest die folgenden Elemente (20, 50, 60, 70) hat:
- einen quaderförmigen Rahmen (20) mit vier langgestreckten, paarweise entgegengesetzten Trägern (31, 32, 41, 42), von denen:
- zwei entgegengesetzte Träger eines ersten Typs (31, 32) mit Profilen polygonalen Querschnitts ausgestaltet sind, die zum Aufeinanderstapeln und Querverstauen mindestens zweier Solartische (10), insbesondere zu Transportzwecken in einem Transportcontainer nach ISO-Normen angepasst sind, und
- zwei entgegengesetzte Träger eines zweiten Typs (41, 42) jeweils mit mechanischen Einrichtungen (50) zur Befestigung des Rahmens (20) an einem Stützbein (90) ausgestattet sind;
- mindestens ein Photovoltaikmodul (60), das am Rahmen (20) befestigt ist; und
- Kabelsegmente (70) zum Transport elektrischer Energie, die von dem oder den Photovoltaikmodulen (60) erzeugt wurde, zum Wechselrichter, wobei die Kabelsegmente (70) über im Wesentlichen ihre Länge an mindestens einem der Träger des ersten Typs (31, 32) angebracht und/oder über im Wesentlichen ihre Länge in einem freien Volumen (33, 34) aufgenommen sind, das im Inneren mindestens eines der Träger des ersten Typs (31, 32) abgegrenzt ist, wobei die Anzahl, die Länge, der Durchmesser und/oder das Material der Kabelsegmente (70), die im Solartisch (10) integriert sind, von seiner vorbestimmten Position im Solarpark (1) abhängen.

10. Solartisch (10) nach Anspruch 9, **dadurch gekennzeichnet, dass** sich die Träger des ersten Typs (31, 32) in einer ersten Länge (L30) erstrecken, sich die Träger des zweiten Typs (41, 42) in einer zweiten Länge (L40) erstrecken, wobei die erste Länge (L30) größer ist als die zweite Länge (L40):
- die erste Länge (L30) ist länger als 8 Meter, vorzugsweise länger als 10 Meter, und
- die zweite Länge (L40) ist länger als 1,50 Meter, vorzugsweise länger als 2 Meter.

11. Solartisch (10) nach einem der Ansprüche 9 oder 10, **dadurch gekennzeichnet, dass** er einen Mittelträger zur Versteifung des Rahmens (20) hat, wobei sich dieser Mittelträger parallel zu den zwei Trägern des ersten Typs (31, 32) erstreckt und die zwei Träger des zweiten Typs (41, 42) verbindet.

12. Solartisch (10) nach einem der Ansprüche 9 bis 11, **dadurch gekennzeichnet, dass** die mechanischen Einrichtungen (50) zur Befestigung des Rahmens (20) an einem der Stützbeine (90) jeweils eine Bewegungsfreiheit des Solartischs (10) in Bezug auf das Stützbein (90) in einer Richtung im Wesentlichen parallel zur den Trägern des ersten Typs (31, 32) zulassen und die relative Positionierung des Solartischs (10) in Bezug auf das Stützbein (90) in allen anderen Raumrichtungen verriegeln.

13. Verfahren zum Bau eines Solarparks (1) nach einem der Ansprüche 1 bis 8, wobei das Verfahren zumindest die folgenden sukzessiven Schritte umfasst:
- einen Schritt a) zur Planung einerseits der Herstellung an einem ersten Standort und andererseits des Einsatzes an einem vom ersten Standort entfernten, zweiten Standort (2), eines Solarparks (1), der mindestens einen Solartisch (10) aufweist;
- einen Teilschritt a1) zur Referenzierung jedes Solartischs (10) in Abhängigkeit von seiner Einbauposition im Solarpark (1) am zweiten Standort (2);
- einen Teilschritt a2) zur Bestimmung der Anzahl und/oder der Länge von in jeden Solartisch (10) integrierten Kabelsegmenten (70) zum Transport elektrischer Energie, in Abhängigkeit von seiner Referenzierung im Teilschritt a1) zur Referenzierung;
- einen Schritt b) zur Fertigung, und zwar am ersten Standort, jedes Solartischs (10), der aufweist:
- einen quaderförmigen Rahmen (20) mit zwei langgestreckten, paarweise entgegengesetzten Trägern (31, 32, 41, 42), von denen:
- zwei entgegengesetzte Träger eines ersten Typs (31, 32) mit Profilen polygonalen Querschnitts ausgestaltet sind, die zum Aufeinanderstapeln und Querverstauen mindestens zweier Solartische (10), insbesondere zu Transportzwecken in einem Transportcontainer nach ISO-Normen angepasst sind, und
- zwei entgegengesetzte Träger eines zweiten Typs (41, 42) jeweils mit mechanischen Einrichtungen (50) zur Befestigung eines Stützbeins (90) am Rahmen (20) ausgestattet sind;
- mindestens ein Photovoltaikmodul (60), das am Rahmen (20) befestigt ist; und
- die Kabelsegmente (70), die über im Wesentlichen ihre Länge an mindestens einem der Träger des ersten Typs (31, 32) angebracht und/oder über im Wesentlichen ihre Länge in einem freien Volumen (33, 34) aufgenommen sind, das im Inneren mindestens eines der Träger des ersten Typs (31, 32) abgegrenzt ist;
- einen Schritt c) zum Einladen des Solarparks (1) in mindestens einen, vorzugsweise nach oben offenen Transportcontainer, wobei jeder Solartisch (10) in dem oder dem einem der Container in Abhängigkeit von seiner Referenzierung im Teilschritt a1) zur Referenzierung angeordnet wird, wobei der Rahmen (20) eines Solartischs (10) insbesondere auf zuvor in den Container eingeladenen Rahmen (20) des Solartischs (10) gestapelt wird;
- einen Schritt d) zum Transport der Container vom ersten Standort zum zweiten Standort;
- einen Schritt e) zur Installation des Solarparks (1) am zweiten Standort (2), wobei jeder Solartisch (10) während seines Ausladens und seiner Installation, die insbesondere mit Hilfe einer Handhabungsmaschine für Solartische (10) erfolgen, eine einstückige vormontierte Einheit bildet, wobei die Einbauposition jedes Solartischs (10) von seiner Referenzierung im Teilschritt a1) zur Referenzierung abhängt, wobei die Kabelsegmente (70) mindestens zwei Solartische (10) mit dem Wechselrichter oder mit dem einen der Wechselrichter (6) verbinden und Ketten von Kabeln bilden, die sich entlang der Ketten von Solartischen (10) erstrecken, und die Anzahl der parallel angeordneten Ketten von Kabeln (70) insbesondere von der Einbauposition jeder Kette von Solartischen (10) im Solarpark (1) abhängt.

## Claims

1. Solar farm (1), comprising at least one inverter and at least two solar tables (10) connected by electric cables (7, 70) to the inverter or to one of the inverters (6), each solar table (10) being adapted to rest on at least two support legs (90) on the ground (2), **characterised in that** each solar table (10) is prefabricated for the purposes of transport and/or installation including at least the following elements (20, 50, 60, 70):
- a parallelepiped frame (20) comprising four extended beams (31, 32, 41, 42), two by two opposite, among which:
- two beams opposite of a first type (31, 32) are configured with profiles of polygonal cross-section, and
- two beams opposite of a second type (41, 42) are each provided with mechanical means (50) for fastening the frame (20) t one of the support legs (90);
- at least one photovoltaic module (60) fixed to the frame (20); and
- cable segments (70) for transporting electric energy generated by the photovoltaic module or modules (60) to the inverter, with the cable segments (70) being attached over most of their length to at least one of the beams of the first type (31, 32) and/or housed over most of their length in a free volume (33, 34) delimited inside at least one of the beams of the first type (31, 32), the number, the length, the diameter and/or the material of the cable segments (70) integrated into each solar table (10) being according to its predetermined position in the solar farm (1).

2. Solar farm (1) according to claim 1, **characterised in that** each solar table (10) comprises cable segments (70) of which the length is between 95% and 120% of the length (L30) of the beams of the first type (31, 32) and of which the number is according to the predetermined position of this solar table (10) in the solar farm (1).

3. Solar farm (1) as claimed in any preceding claim, **characterised in that** when the solar farm (1) is installed, the cable segments (70) form strings of cables that extend along strings of solar tables (10), with the number of strings of cables arranged in parallel being, on the one hand, according to the predetermined position of the string of solar tables (10) in the solar farm (1) and, on the other hand, different for strings of neighbouring solar tables (10).

4. Solar farm (1) as claimed in any preceding claim, **characterised in that** each solar table (10) is adapted to share the same support leg (90) with an adjacent solar table, when at least two solar tables (10) are installed on the ground (2) next to one another with adjacent beams of the second type (41, 42), with the support leg (90) being fixed to the means of fastening (50) fitted to the adjacent beams of the second type (41, 42) of the two solar tables (10).

5. Solar farm (1) as claimed in any preceding claim, **characterised in that** it comprises at least nine solar tables (10) installed on the ground (2), placed side by side over at least three lines (L1-L18) and at least three columns (C1-C18), at least some of the solar tables (10) bordered by less than eight solar tables comprising third mechanical means (50) for fastening to the frame (20) a third support leg (90).

6. Solar farm (1) as claimed in any preceding claim, **characterised in that** each solar table (10) further comprises equipotential bonding cables (80) between solar tables, with these equipotential bonding cables belonging to a lightning protection system and being fixed to the frame (20) of the solar table (10), more preferably during the manufacture of the solar table (10).

7. Solar farm (1) as claimed in any preceding claim, **characterised in that** at least some of the solar tables (10) include at least one photovoltaic module including individual photovoltaic cells connected to the same junction box, in particular in order to obtain an optimum string voltage directly at the output of this photovoltaic module.

8. Solar farm (1) as claimed in any preceding claim **characterised in that** each solar table (10) comprises beams of the first type (31, 32) configured with profiles of polygonal cross-section adapted to be stacked on top of one another and the transversal locking of at least two solar tables (10) in the or one of the containers, with two stacked tables (10) having a height that is less than the sum of their individual heights, with the relative position of the solar tables (10) stacked in the container or containers being according to their predetermined respective position in the solar farm (1).

9. Solar table (10), in particular intended to be fitted to a solar farm (1) according to any of claims 1 to 8, with the solar table (10) being prefabricated for the purposes of transport and/or installation including at least the following elements (20, 50, 60, 70):
- a parallelepiped frame (20) comprising four extended beams (31, 32, 41, 42), two by two opposite, among which:
- two beams opposite of a first type (31, 32) are configured with profiles of polygonal cross-section adapted to be stacked on top of one another and the transversal locking of at least two solar tables (10), in particular for the purposes of transport in a transport container according to ISO standards, and
- two beams opposite of a second type (41, 42) are each provided with mechanical means (50) for fastening the frame (20) to a support leg (90);
- at least one photovoltaic module (60) fixed to the frame (20); and
- cable segments (70) for transporting electric energy generated by the photovoltaic module or modules (60) to the inverter, with the cable segments (70) being attached over most of their length to at least one of the beams of the first type (31, 32) and/or housed over most of their length in a free volume (33, 34) delimited inside at least one of the beams of the first type (31, 32), with the number, the length, the diameter and/or the material of the cable segments (70) integrated into the solar table (10) being according to its predetermined position in the solar farm (1).

10. Solar table (10) according to claim 9, **characterised in that** the beams of the first type (31, 32) extend along a first length (L30), the beams of the second type (41, 42) extend along a second length (L40), the first length (L30) being greater than the second length (L40):
- the first length (L30) is greater than 8 metres, more preferably greater than 10 metres, and
- the second length (L40) is greater than 1.50 metre, more preferably greater than 2 metres.

11. Solar table (10) according to any of claims 9 or 10, **characterised in that** it comprises a central beam for rigidifying the frame (20), with this central beam extending in parallel to the two beams of the first type (31, 32) and connecting the two beams of the second type (41, 42).

12. Solar table (10) according to any of claims 9 to 11, **characterised in that** each of the mechanical means (50) for fastening the frame (20) to one of the support legs (90) authorises a freedom of movement of the solar table (10) in relation to the support leg (90) according to a direction substantially parallel to the beams of the first type (31, 32) and lock the relative positioning of the solar table (10) in relation to the support leg (90) in all of the directions of space.

13. Method of constructing a solar farm (1) according to any of claims 1 to 8, with the method comprising at least the following successive steps:
- a step a) of planning, on the one hand, of the manufacture on a first site and, on the other hand, of the deployment on a second site (2) far from the first site, of a solar farm (1) comprising at least one solar table (10);
- a sub-step a) of referencing each solar table (10) according to its position of installation in the solar farm (1) on the second site (2);
- a sub-step a2) of determining the number and/or the length of cable segments (70) for transporting electric energy integrated into each solar table (10) according to its referencing in the sub-step of referencing a 1);
- a step b) of manufacturing, on the first site, of each solar table (10) comprising:
- a parallelepiped frame (20) comprising four extended beams (31, 32, 41, 42), two by two opposite, among which:
- two beams opposite of a first type (31, 32) are configured with profiles of polygonal cross-section adapted to be stacked on top of one another and the transversal locking of at least two solar tables (10), in particular for the purposes of transport in a transport container according to ISO standards, and
- two beams opposite of a second type (41, 42) are each provided with mechanical means (50) for fastening to the frame (20) a support leg (90);
- at least one photovoltaic module (60) fixed to the frame (20), and
- the cable segments (70) attached over most of their length to at least one of the beams of the first type (31, 32) and/or housed over most of their length in a free volume (33, 34) delimited inside at least one of the beams of the first type (31, 32);
- a step c) of loading the solar farm (1) into at least one transport container, more preferably with opening from the top, each solar table (10) being positioned in the or one of the containers according to its referencing in the sub-step of referencing a1), with the frame (20) of a solar table (10) being in particular stacked on the frame (20) of the solar table (10) previously loaded into the container;
- a step d) of transporting containers from the first site to the second site;
- a step e) of installing the solar farm (1) on the second site (2), each solar table (10) forming a single-block preassembled unit during its unloading and its installation, carried out in particular via a machine for handling solar tables (10), with the position of installation of each solar table (10) being according to its referencing in the sub-step of referencing a1), with the cable segments (70) connecting the at least two solar tables (10) to the inverter or to one of the inverters (6) and forming strings of cables which extend along strings of solar tables (10), with the number of strings of cables (70) arranged in parallel being in particular according to the position of installation of each string of solar table (10) in the solar farm (1).
